# EUROPÄISCHE PATENTSCHRIFT

(11) **EP 1 564 366 B1**
(45) Veröffentlichungstag und Bekanntmachung des Hinweises auf die Patenterteilung: **30.08.2006**
(21) Anmeldenummer: 05002689.7
(22) Anmeldetag: 09.02.2005
(51) Int. Cl.: E21B 17/00, E21B 7/30, G01R 31/02, F16L 11/127

(54) **Verfahren zur grabenlosen Verlegung von Kunststoffrohren**
Method for trenchless laying of plastic pipes
Procédé de pose de tuyaux plastiques sans excavation

(30) Priorität: 11.02.2004 DE 202004002102 U; 20.02.2004 DE 202004002641 U
(43) Veröffentlichungstag der Anmeldung: 17.08.2005
(73) Patentinhaber: Egeplast Werner Strumann GmbH & Co. KG, 48268 Greven (DE)
(72) Erfinder: Dr. Späth Thorsten, 48282 Emsdetten (DE)
(74) Vertreter: Basfeld, Rainer

(56) Entgegenhaltungen:
- DE-A1- 2 304 368
- FR-A- 2 691 203
- US-A- 3 648 282
- US-A- 4 336 415
- US-B1- 6 265 880
- US-B1- 6 361 299

## Beschreibung

Die vorliegende Erfindung betrifft ein Verfahren zur grabenlosen Verlegung von Kunststoffrohren, insbesondere Mehrschichtrohren. Gegenstand der vorliegenden Erfindung ist weiterhin ein erdverlegtes Kunststoffrohr sowie eine Prüfeinrichtung zur Kontrolle einer ordnungsgemäßen grabenlosen Verlegung von Kunststoffrohren.

Bei der sogenannten grabenlosen Verlegung von Kunststoffrohren für Ver- und Entsorgungsleitungen wird heute häufig ein Verfahren angewandt, bei dem das zu verlegende Kunststoffrohr mittels einer entsprechenden Vortriebseinrichtung mit Bohrkopf gezogen wird. Da man bei der grabenlosen Verlegung keine Einsicht in die Verlegestrecke hat, ist es von großer Wichtigkeit, feststellen zu können, ob das Rohr bei der Verlegung durch im Erdreich befindliche scharfkantige Gegenstände verletzt wurde. In manchen Fällen wird auch so vorgegangen, dass eine neue Kunststoffrohrleitung in eine bereits vorhandene ältere Leitung eingezogen wird, um letztere zu ersetzen. Die für Ver- und Entsorgungsleitungen früher verwendeten Druckrohre bestanden meist aus Gusseisen oder Stahl. Bei dieser Variante des Verlegeverfahrens wird die vorhandene alte gusseiserne Leitung zertrümmert und Scherben ins umliegende Erdreich verdrängt. Durch diese wird die neue Leitung nachfolgend eingezogen, so dass es vorkommen kann, dass die neue Rohrleitung durch Scherben der zertrümmerten alten Leitung, die naturgemäß scharfkantig sind, verletzt wird. Zwar wurden für diese Anwendungsfälle Mehrschichtrohre entwickelt, die mindestens eine äußere Schicht mit hoher Härte und Festigkeit aufweisen, beispielsweise aus mineralisch gehärtetem Polypropylen. Die innere Schicht eines solchen Kunststoffrohrs kann beispielsweise aus einem speziellen Polyethylen bestehen, welches die geforderte Druckfestigkeit liefert und andere vorteilhafte Eigenschaften liefert, insbesondere Langzeitstabilität durch sehr hohen Widerstand gegen langsamen Rißfortschritt. Die Gefahr der Beschädigung der Außenschicht aus hochfestem Kunststoff durch scharfkantige Gegenstände im Erdreich beim Rohreinzug besteht aber auch bei diesen Kunststoffrohren nach wie vor.

In der US-A-3.648.282 werden Vorrichtung und Verfahren zur grabenlosen Verlegung von elektrischen Kabeln beschrieben.

In der FR-A-2691203 wird ein endloses Hilfsrohr für geothermische Bohrungen beschrieben. Das Hilfsrohr besteht aus Kunststoff und hat einen vergleichsweise kleinen Durchmesser. Das Hilfsrohr wird in ein Hauptbohrrohr der Brunnenbohrung eingezogen, welches aus Metall bestehen dürfte. Das Hilfsrohr dient lediglich dazu, am Grund der Brunnenbohrung benötigte Hydraulikflüssigkeit zu transportieren. Es wird deshalb angestrebt, dass das Hilfsrohr einen Durchmesser von nicht mehr als 20 bis 30 mm aufweist oder einen noch geringeren Durchmesser, damit es in dem Hauptbohrrohr so wenig Platz wie möglich einnimmt. Ein solches Hydraulikrohr muss vergleichsweise hohen Drucken standhalten, in einer Größenordnung von beispielsweise ca. 100 bar und es besteht daher aus sehr speziellen Kunststoffen, beispielsweise Polyvinylidenfluorid oder einem Copolymeren aus Chlortrifluorethylen und Ethylen. Aufgrund dieser Materialien sind solche Rohrleitungen sehr kostspielig, so dass sie nur für den genannten speziellen Anwendungsfall in Betracht kommen, nicht aber für großvolumige horizontal zu verlegende Ver- und Entsorgungsleitungen aus Kunststoff, die in öffentlichen und privaten Netzen benötigt werden und von denen folglich große Längen verlegt werden.

Die WO95/31665 beschreibt einen Schlauch für fluide Medien, die ein abrasives Material enthalten und unter hohem Druck gefördert werden, zum Beispiel zum Sandstrahlen oder dergleichen. Auch hier handelt es sich um eine sehr spezielle Anwendung, wobei es in dieser Druckschrift darum geht, wegen des Transports des unter hohem Druck stehenden und abrasives Material enthaltenen Fluids das Innere des Schlauchs und nicht dessen Außenhaut zu schützen.

Folglich wird in diesem Verfahren ein elektrisch leitender Draht in eine Schicht aus einem gummiartigen Material einextrudiert in Nähe des Innenquerschnitts, um so frühzeitig zu erfahren, wenn der Schlauch innenseitig verletzt wird, so dass dann das System sofort drucklos gestellt werden kann. Der elektrisch leitende Draht kann aus Aluminium bestehen und sich helikal innerhalb der inneren gummiartigen Schicht erstrecken. Der Schlauch weist auch eine äußere gummiartige Deckschicht auf und ist in sich flexibel, was für die Anwendung, nämlich zum Transport eines Mediums zum Sandstrahlen oder dergleichen notwendig ist. Bei der grabenlosen Verlegung von vergleichsweise starren Kunststoffrohren für Ent- und Versorgungsleitungen ergeben sich ganz andere Probleme als bei dem aus der vorgenannten Druckschrift bekannten Schlauch. Zum einen ist eine Verletzung der Rohrleitung im Außenbereich zu erwarten aufgrund des eingangs beschriebenen Verlegeverfahrens. Zum anderen ist auch die Problemlösung bei Auftreten einer Beschädigung nicht so einfach zu bewerkstelligen wie bei dem bekannten Schlauch. Tritt dort eine Beschädigung auf, wird der beschädigte Schlauch ausgetauscht und das Sandstrahlverfahren kann fortgesetzt werden. Die Feststellung einer Beschädigung des Schlauchs dient also der Sicherheit der mit dieser Vorrichtung arbeitenden Person. Kunststoffrohre für Ent- und Versorgungsleitungen werden gegebenenfalls über große Wegstrecken horizontal im Erdreich verlegt und verbleiben nach der Verlegung über einen sehr langen Zeitraum im Erdreich. Es kann beispielsweise eine Lebensdauer von 100 Jahren gefordert werden. Der Verlegevorgang bei der grabenlosen Verlegung ist technisch vergleichsweise aufwändig. Die Verlegung kann in Bereichen erfolgen, in denen danach streckenweise keine Zugänglichkeit zu der Rohrleitung mehr gegeben ist.

Erfindungsgemäß geht es also darum, eine Beschädigung der Rohrleitung festzustellen, die in der Regel bei der Verlegung auftritt, so dass man anschließend die Möglichkeit hat, die Fehlstelle gegebenenfalls zu orten und wenn eine Reparatur nicht möglich ist muss eine vollständig neue Rohrleitung verlegt werden. Das die Rohrleitung verlegende Unternehmen muss sicherstellen, dass die Rohrleitung beschädigungsfrei verlegt wurde, damit sie danach über einen sehr langen Zeitraum im Erdreich verbleiben kann, um unter Druck stehende Medien (zum Beispiel bei Gasleitungen 10 bar) wie Gas oder Trinkwasser einwandfrei zu transportieren. Es liegt auf der Hand, dass eine Leckage insbesondere bei einer Gasleitung gefährlich werden kann. Es sind auch solche Beschädigungen bei der Verlegung zu vermeiden, die erst nach einem langen Zeitraum zu einer Leckage führen. Bei Trinkwasserleitungen sind mögliche Leckagen auch wegen der Kontaminationsgefahr problematisch. Anders als bei den eingangs beschriebenen Anwendungsfällen, die aus dem Stand der Technik bekannt sind, können Rohrleitungen aus Kunststoff für die Ver- oder Entsorgung Durchmesser von bis zu 1,20 m und Wandstärken von mehreren cm aufweisen. Verglichen mit dem zuvor beschriebenen Druckschlauch sind diese Rohrleitungen daher vergleichsweise starr.

Die Aufgabe der vorliegenden Erfindung besteht darin, ein Verfahren zur grabenlosen Verlegung von Kunststoffrohren für Ver- und Entsorgungsleitungen zur Verfügung zu stellen, welches eine effektive Kontrolle bezüglich einer ordnungsgemäßen Verlegung zulässt. Aufgabe der Erfindung ist es weiterhin, eine Einrichtung zur Überprüfung einer ordnungsgemäßen Verlegung von Ver- und Entsorgungsleitungen, die grabenlos verlegt werden, zur Verfügung zu stellen. Aufgabe der Erfindung ist es weiterhin, ein Kunststoffrohr bereitzustellen, welches zur Verwendung in einem Verfahren zur grabenlosen Verlegung der vorgenannten Art geeignet ist.

Die Lösung der Aufgabe liefert ein Verfahren zur grabenlosen Verlegung von Kunststoffrohren mit den Merkmalen des Patentanspruchs 1 beziehungsweise ein Kunststoffrohr zur Verwendung in einem solchen Verfahren mit den Merkmalen des Anspruchs 6 beziehungsweise eine Einrichtung zur Überprüfung einer ordnungsgemäßen Verlegung von Ver- und Entsorgungsleitungen mit den Merkmalen des Anspruchs 14.

Nach dem erfindungsgemäßen Verfahren erfolgt zunächst die Verlegung einer Rohrleitung aus Kunststoff mittels einer angetriebenen Vorrichtung, die die Rohrleitung durch das Erdreich zieht. Dabei wird eine Kunststoffrohrleitung verwendet, bei der mindestens ein elektrischer Leiter wendelförmig in der Rohrwandung angeordnet ist. Nach der Verlegung der gewünschten Rohrleitungslänge kann dann geprüft werden, ob die Rohrleitung durch spitze Gegenstände im Erdreich beschädigt wurde. Tritt eine solche Beschädigung ein, dann wird das horizontal im Erdreich vorgeschobene Kunststoffrohr quasi im Bereich seiner Außenwandung aufgeschlitzt, wodurch der dort wendelförmig angeordnete Leiter durchtrennt wird. Dadurch würde der Stromkreis unterbrochen. Wenn man nach der Verlegung mit einem entsprechenden Messgerät nach Anlegen einer Spannung prüft, ob ein Strom fließt oder nicht, kann man dadurch feststellen, ob der wendelförmige Leiter beschädigt wurde. Diese Überprüfung kann beispielsweise durch ein einfaches Widerstandsmessgerät oder mittels eines Spannungsprüfers nach Anlegen einer Spannung an das eine Ende des wendelförmigen Leiters erfolgen. Es können beispielsweise auch zwei wendelförmige Leiter in der Rohrwandung vorhanden sein, deren jeweilige Enden am Ende der Rohrleitung austreten und miteinander verbunden werden können, so dass durch Verbinden der jeweiligen Enden der Leiter am anderen Ende der Rohrleitung ein geschlossener Stromkreis entsteht.

Bei den erfindungsgemäßen Kunststoffrohrleitungen handelt es sich vorwiegend um Ver- oder Entsorgungsleitungen für Wasser, Abwasser oder Frischwasser in öffentlichen oder auch in privaten Netzen. Die Rohrwandung solcher Kunststoffrohre hat in der Regel einen mindestens zweischichtigen Aufbau, wobei eine innere Schicht vorzugsweise aus einem etwas weicheren Polyethylen besteht, welches gute Eigenschaften im Hinblick auf die gewünschte Druckfestigkeit liefert (zum Beispiel 10 bar bei Gasleitungen). Die äußere Schicht der Rohrwandung, die eine geringere Materialstärke aufweisen kann als die innere Schicht, sollte eine besonders hohe Abriebfestigkeit haben. Dazu kann man die äußere Schicht beispielsweise aus Polypropylen oder Polyethylen hoher Dichte ausbilden und für eine weitere Erhöhung der Abriebfestigkeit kann man Füllkörper großer Härte in die äußere Schicht der Rohrwandung einarbeiten, beispielsweise Füllkörper aus Quarz.

Es ist gemäß einer bevorzugten Weiterbildung der Erfindung besonders vorteilhaft, wenn man einen wendelförmigen elektrischen Leiter aus Kupfer verwendet, vorzugsweise ein vergleichsweise flaches Kupferband, welches sich um die innere Rohrleitungsschicht wickeln lässt und eine besonders feste dichte Auflage der äußeren Schicht der Wandung auf der inneren Schicht mit einer hohen Verbundfestigkeit zulässt. Nach dem Aufwickeln des wendelförmigen elektrischen Leiters auf die innere Schicht kann die äußere Schicht der Rohrwandung auf die innere Schicht aufextrudiert werden. Es hat sich gezeigt, dass Polyethylen als Material für solche Kunststoffrohrleitungen eine besonders große Langzeitstabilität aufweist, die eine hohe Lebensdauer der Kunststoffrohrleitung von beispielsweise bis zu 100 Jahren ermöglicht. Dennoch ist bei Verwendung von Polyethylenen beziehungsweise Polypropylenen eine vergleichsweise kostengünstige Herstellung der Kunststoffrohre möglicht.

Eine bevorzugte Weiterbildung der erfindungsgemäßen Aufgabenlösung sieht vor, dass eine bei der grabenlosen Verlegung entstandene Beschädigung der Rohrleitung aus Kunststoff durch eine geeignete Messvorrichtung geortet wird und/oder die genaue Lage einer verlegten Rohrleitung eingemessen wird. Beispielsweise kann man den wendelförmigen Leiter mit elektromagnetischer Strahlung beaufschlagen, die sich dann in dem Leiter bis zu der Fehlstelle fortpflanzt, wobei mindestens ein Anteil der Wellen reflektiert wird und aus den dadurch entstandenen Interferenzen auf den Abstand der Fehlstelle vom Rohrende geschlossen werden kann. Man kann beispielsweise auch den Leiter mit einer Wechselspannung beaufschlagen und von der Erdoberfläche aus ein Magnetfeld messen und aus einer Unterbrechung im Magnetfeld auf eine dortige Beschädigung der Rohrleitung schließen. Denkbar wäre auch eine kapazitive Widerstandsmessung.

Die in den Unteransprüchen genannten Merkmale betreffen bevorzugte Weiterbildungen der erfindungsgemäßen Aufgabenlösung. Weitere Vorteile der Erfindung ergeben sich aus der nachfolgenden Detailbeschreibung. Darin zeigen
- Fig. 1: einen schematisch vereinfachten Querschnitt durch eine erfindungsgemäße Rohrleitung aus Kunststoff,
- Fig. 2: einen schematisch vereinfachten Längsschnitt durch eine erfindungsgemäße Rohrleitung aus Kunststoff,
- Fig. 3: eine schematisch vereinfachte Darstellung einer erfindungsgemäßen Einrichtung zur Überprüfung der ordnungsgemäßen Verlegung der Rohrleitung.

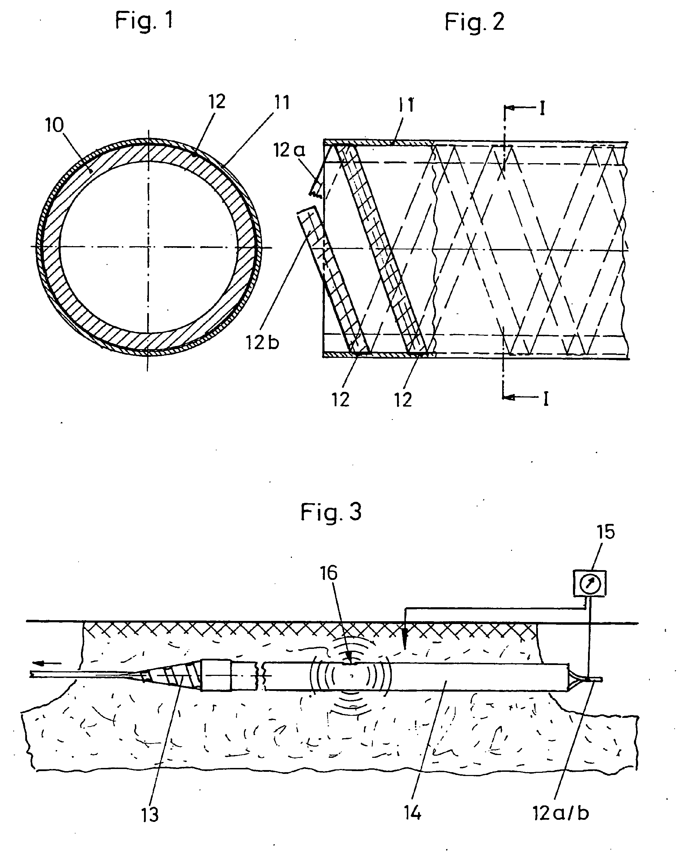

Zunächst wird auf Fig. 1 Bezug genommen. Die Darstellung zeigt einen Querschnitt durch eine erfindungsgemäße Rohrleitung aus Kunststoff, deren Wandung zweischichtig aufgebaut ist mit einer Innenschicht 10 aus Polyethylen, um die außen ein wendelförmiger Leiter in Form eines flachen Kupferbandes 12 gewickelt ist. Dieser wendelförmige Leiter 12 wird überdeckt von einer besonders harten Außenschicht 11, die einen festen Verbund mit der inneren Schicht eingeht und beispielsweise auf die innere Schicht 10 aufextrudiert ist. Die äußere Schicht besteht beispielsweise aus Polypropylen, welches gegebenenfalls zusätzlich Füllkörper aus einem Material großer Härte aufweist, beispielsweise aus Quarz, um die Abriebfestigkeit der äußeren Schicht zu erhöhen. Die Materialstärke der äußeren Schicht 11 der Rohrwandung kann geringer sein als die der inneren Schicht 10. Fig. 2 zeigt die entsprechende Seitenansicht beziehungsweise einen Längsschnitt einer erfindungsgemäßen Rohrleitung aus Kunststoff, wobei endseitig die Enden des wendelförmig angeordneten flachen Kupferbands, welches als elektrischer Leiter dient, austreten, so dass man für die Prüfung einer ordnungsgemäßen Verlegung beispielsweise an diese Enden eine Spannung anlegen kann, um festzustellen, ob der wendelförmige Leiter unbeschädigt und somit die Rohrleitung nach der Verlegung intakt ist.

Fig. 3 zeigt in schematisch vereinfachter Darstellung eine erfindungsgemäße Einrichtung, mittels derer man die ordnungsgemäße Verlegung der Rohrleitung überprüfen kann. Die Darstellung zeigt einen Bohrkopf 13, der angetrieben ist und an dem die Rohrleitung 14 angebracht ist, so dass diese bei der grabenlosen Verlegung durch das Erdreich gezogen werden kann. Nach der Verlegung wird mittels eines Messgeräts 15 beispielsweise eine Spannung an die endseitig aus der Rohrleitung 14 austretenden Leiter 12a, 12b angelegt und es wird beispielsweise eine einfache Widerstandsmessung vorgenommen, um festzustellen, ob der sich in der Wandung der verlegten Rohrleitung erstreckende elektrische Leiter 12 intakt ist.

Um eine eventuell festgestellte beschädigte Stelle 16 nach der Verlegung oberirdisch zu orten, kann man beispielsweise eine Wechselspannung auf die Leiterenden 12a, 12b geben und mittels eines Messgeräts 15 die Strecke über der verlegten Rohrleitung ablaufen, um durch Induktionsmessung die beschädigte Stelle 16 zu orten. Wenn dies möglich ist, kann an dieser Stelle das Erdreich aufgegraben und die Rohrleitung repariert werden oder ein Ersatzstück in die Rohrleitungsstrecke eingesetzt werden. In manchen Fällen ist dies nicht möglich und es muss dann die Rohrleitung erneut verlegt werden.

### Bezugszeichenliste

- 10: innere Schicht der Rohrwandung
- 11: äußere Schicht der Rohrwandung
- 12: flaches Kupferband (wendelförmig)
- 12a, b: Leiterende
- 13: Bohrkopf
- 14: Rohrleitung
- 15: Messgerät
- 16: beschädigte Stelle

## Patentansprüche

1. Verfahren zur grabenlosen Verlegung von Kunststoffrohren für Ver- und Entsorgungsleitungen, bei dem das Kunststoffrohr mittels einer angetriebenen Vorrichtung im Wesentlichen horizontal durch das Erdreich gezogen wird, wobei nach dem Verlegevorgang geprüft wird, ob die Rohrwandung des Kunststoffrohrs im Außenbereich durch im Erdreich befindliche Gegenstände beschädigt wurde,
**dadurch gekennzeichnet, dass** ein mindestens eine Innenschicht (10) aus Kunststoff und mindestens eine Außenschicht (11) aus Kunststoff sowie mindestens einen wendelförmig zwischen Innenschicht und Außenschicht angeordneten elektrischen Leiter (12) umfassendes Kunststoffrohr in das Erdreich eingezogen wird, wobei der elektrische Leiter (12) einen geschlossenen elektrischen Stromkreis bildet und dass nach dem Verlegevorgang mittels einer Messeinrichtung (15) der Stromfluss durch den Leiter geprüft und anhand dessen entschieden wird, ob das Kunststoffrohr beschädigungsfrei verlegt wurde.

2. Verfahren nach Anspruch 1, **dadurch gekennzeichnet, dass** nach der Verlegung die Rohrleitung eingemessen wird und die genaue Lage der Rohrleitung festgestellt und/oder mittels einer Messvorrichtung der Ort einer festgestellten Leckage ermittelt wird.

3. Verfahren nach Anspruch 1 oder 2, **dadurch gekennzeichnet, dass** nach der Verlegung mittels einer Messvorrichtung eine Beschädigung der Kunststoffrohrleitung über ein elektromagnetisches Feld geortet wird.

4. Verfahren nach einem der Ansprüche 1 bis 3, **dadurch gekennzeichnet, dass** nach der Verlegung der wendelförmig angeordnete Leiter (12) mit einer elektromagnetischen Welle beaufschlagt und die Leckstelle über dabei auftretende Interferenzen geortet wird.

5. Verfahren nach einem der Ansprüche 1 bis 3, **dadurch gekennzeichnet, dass** nach der Verlegung der Rohrleitung eine Leckstelle über die Messung eines Magnetfeldes oder eine kapazitive Widerstandsmessung geortet wird.

6. Kunststoffrohr zur Verwendung in einem Verfahren zur grabenlosen Verlegung von Ver- und Entsorgungsleitungen nach einem der Ansprüche 1 bis 5, umfassend mindestens einen wendelförmig angeordneten elektrischen Leiter (12), der möglichst nahe der Außenwandung des Kunststoffrohrs verläuft, **dadurch gekennzeichnet, dass** das Kunststoffrohr als mehrschichtiges Rohr ausgebildet ist, das mindestens eine Innenschicht (10), mindestens eine Außenschicht (11) und mindestens einen zwischen der Innenschicht (10) und der Außenschicht (11) angeordneten wendelförmig verlaufenden elektrischen Leiter (12) umfasst, wobei die mindestens eine Außenschicht (11) Füllkörper hoher Abriebfestigkeit, vorzugsweise Füllkörper aus Quarz oder Glas enthält.

7. Kunststoffrohr nach Anspruch 6, **dadurch gekennzeichnet, dass** als elektrischer Leiter mindestens ein Kupferdraht dient.

8. Kunststoffrohr nach Anspruch 6, **dadurch gekennzeichnet, dass** als elektrischer Leiter mindestens ein flaches Kupferband (12) vorgesehen ist.

9. Kunststoffrohr nach einem der Ansprüche 6 bis 8, **dadurch gekennzeichnet, dass** als Innenschicht (10) mindestens eine Polyethylenschicht vorgesehen ist.

10. Kunststoffrohr nach einem der Ansprüche 6 bis 9, **dadurch gekennzeichnet, dass** als mindestens eine äußere Schicht (11) eine Polypropylenschicht vorgesehen ist.

11. Kunststoffrohr nach einem der Ansprüche 6 bis 10, **dadurch gekennzeichnet, dass** dieses einen Außendurchmesser von mindestens 20 mm, vorzugsweise von zwischen etwa 25 mm und etwa 1.200 mm aufweist.

12. Einrichtung zur Überprüfung einer ordnungsgemäßen Verlegung von Ver- und Entsorgungsleitungen, die grabenlos verlegt werden, umfassend eine im Erdreich verlegte Rohrleitung, die mindestens einen in der Rohrwandung angeordneten wendelförmig verlaufenden elektrischen Leiter (12) aufweist, sowie mindestens ein Messgerät zur Überprüfung eines Stromflusses durch den wendelförmig verlaufenden Leiter (12) bei Anlegen einer Spannung, **dadurch gekennzeichnet, dass** die Einrichtung mindestens ein Kunststoffrohr nach einem der Ansprüche 6 bis 11 umfasst.

13. Einrichtung nach Anspruch 12, **dadurch gekennzeichnet, dass** diese mindestens ein Messgerät zur Ortung einer Beschädigung der Rohrleitung aus Kunststoff umfasst, welches eine Interferenz einer elektromagnetischen Welle erfasst, mit der der wendelförmig aufgebrachte Leiter beaufschlagt wurde oder welches einen kapazitiven Widerstand misst oder welches ein Magnetfeld misst bei Beaufschlagung des Leiters mit einer Wechselspannung.

## Claims

1. Method for laying plastic pipes without a trench for supply lines and waste disposal lines, in which the plastic pipe is drawn essentially horizontally through the ground by means of a driven apparatus, with a check being carried out after the laying process to determine whether the pipe wall of the plastic pipe has been damaged in the outer area by objects located in the ground,
**characterized in that** a plastic pipe which comprises at least one inner layer (10) composed of plastic and at least one outer layer (11) composed of plastic as well as at least one electrical conductor (12) arranged in a helical shape between the inner layer and the outer layer is drawn into the ground, with the electrical conductor (12) forming a closed electrical circuit, and **in that**, after the laying process, a measurement device (15) is used to check the current flow through the conductor, and this is used as the basis to decide whether the plastic pipe has been laid without being damaged.

2. Method according to claim 1, **characterized in that** the pipeline is measured after being laid, and the precise position of the pipeline is detected, and/or the location of any leakage found is determined by means of a measurement apparatus.

3. Method according to claim 1 or 2, **characterized in that**, after laying, damage to the plastic pipeline is located via an electromagnetic field by means of a measurement apparatus.

4. Method according to one of claims 1 to 3, **characterized in that**, after laying, the conductor (12) which is arranged in a helical shape has an electromagnetic wave applied to it, and the leakage point is located by means of the interference which occurs in this case.

5. Method according to one of claims 1 to 3, **characterized in that**, once the pipeline has been laid, a leakage point is located by measurement of a magnetic field, or by a capacitive impedance measurement.

6. Plastic pipe for use in a method for laying supply lines and waste disposal lines without a trench according to one of claims 1 to 5, comprising at least one electrical conductor (12) which is arranged in a helical shape and runs as close as possible to the outer wall of the plastic pipe, **characterized in that** the plastic pipe is in the form of a multilayer pipe, which has at least one inner layer (10), at least one outer layer (11) and at least one electrical conductor (12) which runs in a helical shape and is arranged between the inner layer (10) and the outer layer (11), with the at least one outer layer (11) containing filling bodies with high wear resistance, preferably filling bodies composed of quartz or glass.

7. Plastic pipe according to claim 6, **characterized in that** at least one copper wire is used as the electrical conductor.

8. Plastic pipe according to claim 6, **characterized in that** at least one flat copper strip (12) is provided as the electrical conductor.

9. Plastic pipe according to one of claims 6 to 8, **characterized in that** at least one polyethylene layer is provided as the inner layer (10).

10. Plastic pipe according to one of claims 6 to 9, **characterized in that** a polypropylene layer is provided as at least one outer layer (11).

11. Plastic pipe according to one of claims 6 to 10, **characterized in that** the plastic pipe has an external diameter of at least 20 mm, preferably from between about 25 mm to about 1200 mm.

12. Device for checking correct laying of supply lines and waste disposal lines which are laid without a trench, comprising a pipeline which is laid in the ground and has at least one electrical conductor (12) which runs in a helical shape and is arranged in the pipe wall, as well as at least one instrument for checking the current flow through the conductor (12) which runs in a helical shape when a voltage is applied, **characterized in that** the device has at least one plastic pipe according to one of Claims 6 to 11.

13. Device according to claim 12, **characterized in that** the device has at least one instrument for location of damage to the pipeline composed of plastic, which instrument detects the interference from an electromagnetic wave which has been applied to the conductor which is fitted in a helical shape, or which measures a capacitive impedance, or which measures a magnetic field when an AC voltage is applied to the conductor.

## Revendications

1. Procédé de pose sans tranchée de tuyaux en matière plastique pour canalisations d'alimentation et d'évacuation, dans lequel le tuyau en matière plastique est rentré au moyen d'un dispositif motorisé sensiblement à l'horizontale dans la terre, par lequel on vérifie, après l'opération de pose, si la paroi de tuyau du tuyau en matière plastique a été endommagée sur l'extérieur par des objets se trouvant dans la terre,
**caractérisé en ce qu'**un tuyau en matière plastique comportant au moins une couche intérieure (10) de matière plastique et au moins une couche extérieure (11) de matière plastique ainsi qu'au moins un conducteur électrique (12) disposé en spirale entre la couche intérieure et la couche extérieure est rentré dans la terre, tandis que le conducteur électrique (12) constitue un circuit de courant électrique fermé et **en ce qu'**après l'opération de pose, on vérifie au moyen d'un dispositif de mesure (15) le flux de courant dans le conducteur et qu'on décide à partir de là si le tuyau en matière plastique a été posé sans endommagement.

2. Procédé selon la revendication 1, **caractérisé en ce qu'**après la pose, on mesure la canalisation et on détecte la position précise de la canalisation et/ou on détermine au moyen d'un dispositif de mesure l'emplacement d'une fuite détectée.

3. Procédé selon la revendication 1 ou 2, **caractérisé en ce qu'**après la pose, on localise au moyen d'un dispositif de mesure un endommagement de la canalisation en matière plastique à l'aide d'un champ électromagnétique.

4. Procédé selon l'une quelconque des revendications 1 à 3, **caractérisé en ce qu'**après la pose, on sollicite le conducteur disposé en spirale (12) au moyen d'une onde électromagnétique et qu'on localise le point de fuite à l'aide des interférences survenant alors.

5. Procédé selon l'une quelconque des revendications 1 à 3, **caractérisé en ce qu'**après la pose de la canalisation, on localise un point de fuite par mesure d'un champ magnétique ou par mesure de résistance capacitive.

6. Tuyau en matière plastique à utiliser dans un procédé de pose sans tranchée de canalisations d'alimentation et d'évacuation selon l'une quelconque des revendications 1 à 5, comportant au moins un conducteur électrique disposé en spirale (12) qui s'étend aussi près que possible de la paroi extérieure du tuyau en matière plastique, **caractérisé en ce que** le tuyau en matière plastique est réalisé sous forme d'un tuyau multicouche comprenant au moins une couche intérieure (10), au moins une couche extérieure (11) et au moins un conducteur électrique (12) s'étendant en spirale entre la couche intérieure (10) et la couche extérieure (11), tandis que l'au moins une couche extérieure (11) contient des corps de remplissage à haute résistance à l'usure, de préférence des corps de remplissage en quartz ou en verre.

7. Tuyau en matière plastique selon la revendication 6, **caractérisé en ce qu'**on utilise comme conducteur électrique au moins un fil de cuivre.

8. Tuyau en matière plastique selon la revendication 6, **caractérisé en ce qu'**il est prévu comme conducteur électrique au moins une bande de cuivre plate (12).

9. Tuyau en matière plastique selon l'une quelconque des revendications 6 à 8, **caractérisé en ce qu'**il est prévu comme couche intérieure (10) au moins une couche de polyéthylène.

10. Tuyau en matière plastique selon l'une quelconque des revendications 6 à 9, **caractérisé en ce qu'**il est prévu comme au moins une couche extérieure (11) une couche de polypropylène.

11. Tuyau en matière plastique selon l'une quelconque des revendications 6 à 10, **caractérisé en ce qu'**il a un diamètre extérieur d'au moins 20 mm, de préférence situé entre environ 25 mm et environ 1 200 mm.

12. Dispositif de contrôle d'une pose correcte de canalisations d'alimentation et d'évacuation posées sans tranchée, comprenant une canalisation posée dans la terre, qui comporte au moins un conducteur électrique (12) disposé suivant une extension en forme de spirale dans la paroi du tuyau ainsi qu'au moins un appareil de mesure pour vérifier un flux de courant dans le conducteur s'étendant en spirale (12) tout en appliquant une tension, **caractérisé en ce que** ce dispositif comprend au moins un tuyau en matière plastique selon l'une quelconque des revendications 6 à 11.

13. Dispositif selon la revendication 12, **caractérisé en ce qu'**il comporte au moins un appareil de mesure pour localiser un endommagement de la canalisation en matière plastique, qui enregistre une interférence d'une onde électromagnétique avec laquelle le conducteur installé en spirale a été sollicité ou qui mesure une résistance capacitive ou qui mesure un champ magnétique lors d'une sollicitation du conducteur avec une tension alternative.
